Europäisches Patentamt

European Patent Office

Office européen des brevets

(11) Numéro de publication : **0 350 362 B1**

# (12) FASCICULE DE BREVET EUROPEEN

(45) Date de publication du fascicule du brevet :
23.06.93 Bulletin 93/25

(51) Int. Cl.⁵ : **C03C 17/245,** C23C 14/08, C23C 14/58

(21) Numéro de dépôt : **89401758.1**

(22) Date de dépôt : **22.06.89**

(54) **Procédé pour produire une couche transparente à faible résistivité.**

Le dossier contient des informations techniques présentées postérieurement au dépôt de la demande et ne figurant pas dans le présent fascicule.

(30) Priorité : **08.07.88 FR 8809284**

(43) Date de publication de la demande :
**10.01.90 Bulletin 90/02**

(45) Mention de la délivrance du brevet :
**23.06.93 Bulletin 93/25**

(84) Etats contractants désignés :
**BE CH DE ES FR GB IT LI LU NL**

(56) Documents cités :
EP-A- 0 108 616
DE-A- 1 909 869
DE-A- 3 203 416
GB-A- 2 054 659
US-A- 3 655 545
JOURNAL OF APPLIED PHYSICS, vol. 57, no. 2, 15 janvier 1985, pages 384-392, American Institute of Physics, Woodbury, New York, US; K. SREENIVAS et al.: "Preparation and characterization of rf sputtered indium tin oxide films"
THIN SOLID FILMS, vol. 121, no. 2, novembre 1984, pages 109-119, Elsevier Sequoia, Lausanne, CH; A.J.P. THEUWISSEN et al.: "Optical and electrical properties of reactively D.C. magnetron-sputtered In2O3:Sn films"

(56) Documents cités :
THIN SOLID FILMS, vol. 72, no. 3, octobre 1980, pages 469-474, Elsevier Sequoia S.A., Lausanne, CH; J.F. SMITH et al.: "Reactive magnetron deposition of transparent conductive films"
THIN SOLID FILMS, vol. 101, no. 1, mars 1983, pages 7-10, Elsevier Sequoia, Lausanne, CH; M. FUJINAKA et al.: "Thin-doped In2O3 films deposited by r.f. sputtering"

(73) Titulaire : **SAINT-GOBAIN VITRAGE INTERNATIONAL**
**18, avenue d'Alsace**
**F-92400 Courbevoie (FR)**

(72) Inventeur : **Brochot, Jean-Pierre**
**5, rue du Gl. de Mauduy**
**F-75014 Paris (FR)**
Inventeur : **Pillias, Danielle**
**37, rue Francis Crenot**
**F-93600 Aulnay Sous Bois (FR)**
Inventeur : **Wuest, Isabelle**
**11, Passage de la Main d'Or**
**F-75011 Paris (FR)**
Inventeur : **Baufays, Jean-Pierre**
**15, rue du Faux**
**B-5700 Jemeppes Sur Sambre (BE)**
Inventeur : **Darmont, Maurice**
**35, rue Higuet**
**B-5700 Sambreville (BE)**

(74) Mandataire : **de Toytot, Robert et al**
**SAINT-GOBAIN RECHERCHE 39 quai Lucien Lefranc B.P. 135**
**F-93304 Aubervilliers Cédex (FR)**

EP 0 350 362 B1

## Description

L'invention est relative aux couches transparentes conductrices à base d'oxyde d'indium dopé l'étain et plus particulièrement à celles obtenues par pulvérisation cathodique sur un support en verre.

Lorsqu'on veut réaliser des couches transparentes conductrices destinées soit à réduire les échanges thermiques par rayonnement (couches à basse émissivité) soit à provoquer l'échauffement d'un vitrage par effet Joule comme c'est le cas par exemple pour les pare-brise d'automobile chauffants, on désire qu'une couche d'épaisseur donnée, épaisseur le plus souvent déterminée pour des raisons optiques, possède la meilleure efficacité possible. Une bonne mesure de cette efficacité est donnée par la résistivité $\rho$ de la couche, plus celle-ci est faible, meilleure est la performance électrique et en général, de manière concommittante, plus grande est l'action sur le rayonnement infra-rouge, réflexion ou basse émissivité.

Parmi les méthodes proposées pour réaliser les couches conductrices transparentes à base d'oxyde d'indium dopé à l'étain (ITO), les plus courantes sont les techniques sous vide, spécialement la pulvérisation cathodique réactive à partir d'une cible métallique constituée d'un alliage d'indium et d' étain telle que la méthode décrite par exemple dans le brevet US-A-4 336 119. Cette méthode employée telle quelle aboutit à des résultats insuffisants en particulier pour la réalisation de couches très conductrices. On obtient, en général, en effet, des couches peu transparentes et peu conductrices. La solution proposée dans la demande de brevet FR-A-2 555 613 qui préconise de chauffer le substrat avant le dépôt améliore nettement les choses et permet d'obtenir de bonnes transparences en même temps que de bonnes conductibilités. Mais sur le plan industriel, le fait d'introduire du verre chaud dans une installation sous vide et d'y maintenir sa température pendant la durée du dépôt d'une couche épaisse entraîne des difficultés techniques considérables.

Il est connu d'obtenir le même résultat par étapes successives : pulvérisation cathodique sur un support froid puis traitements thermiques. Le brevet FR-B-1 068 807 propose ainsi de déposer l'ITO dans des conditions sous stoechiométriques en oxygène puis d'accroître sa transmission lumineuse en portant l'ensemble sorti de l'installation de vide, pendant par exemple cinq minutes à une température de 350°C. Cette procédure aboutit en général à une couche transparente mais peu conductrice. Un deuxième traitement thermique, en atmosphère réductrice cette fois-ci a été proposé de manière à améliorer la conductibilité (brevet DE-C-24 41 862).

Un procédé semblable est également décrit dans le brevet EP 108 616 où l'on désire obtenir qu'une couche d'ITO déposée par pulvérisation cathodique réactive subisse sans se fissurer le bombage du verre support et conserve des propriétés optiques finales minimales. Dans ce procédé, on définit des conditions générales de transmission indépendemment de l'épaisseur de la couche et les qualités intrinsèques de cette dernière ne sont donc pas prises en compte.

La présente invention se donne pour tâche de définir précisément les conditions à respecter par la couche d'ITO obtenue par pulvérisation cathodique réactive de manière à garantir la meilleure conductibilité électrique au produit final d'épaisseur donnée ou d'obtenir des performances optiques et électriques données avec une épaisseur minimum.

L'invention propose un procédé de contrôle de la pulvérisation cathodique réactive pour l'obtention d'un verre revêtu d'une couche très conductrice à base d'oxyde d'indium-étain comprenant d'abord une première phase de dépôt réactif à partir d'une cible d'un alliage d'indium avec au moins 2 % d'étain et un mélange d'argon et d'oxygène dans le plasma et un traitement thermique ultérieur comprenant une phase réductrice et dans lequel, à l'issue de la première phase, on vérifie que le coefficient d'absorption intrinsèque a de la couche est supérieur à un seuil donné, fonction de la résistivité $\rho$ recherchée.

Selon l'invention, pour obtenir une résistivité $\rho$ inférieure à $3,5.10^{-4}$ ohms.cm avec un alliage sensiblement à 10 % d'étain, on vérifie que le coefficient d'absorption intrinsèque $\alpha$ de la couche est supérieur à 7500 cm$^{-1}$ pour une longueur d'onde de sensiblement 550 nm et pour obtenir une résistivité $\rho$ inférieure à $2,5.10^{-4}$ ohms.cm avec un alliage sensiblement à 10 % d'étain, on vérifie que le coefficient d'absorption intrinsèque $\alpha$ de la couche est supérieur à 23 000 cm$^{-1}$ pour une longueur d'onde de sensiblement 550 nm.

Conformément à l'invention, le coefficient d'absorption intrinsèque $\alpha$ est déterminé à partir de mesures de l'épaisseur de la couche d et des transmissions T et réflexion R de la couche à une longueur d'onde de sensiblement 550 nm, la formule étant :

$$\alpha = \frac{-\text{Ln}\dfrac{T}{1-R}}{d}$$

Le procédé de contrôle de l'invention prévoit qu'un dispositif de mesure de l'intensité lumineuse des raies émises par le plasma soit installé, qu'un étalonnage associant l'intensité d'une raie du plasma et le taux d'oxygène dans le plasma ait été effectué et que le coefficient d'absorption intrinsèque a prévu soit déduit de la mesure de l'intensité lumineuse d'une raie du plasma.

Le problème posé consistait à définir précisément les conditions de mise en oeuvre du procédé de pulvérisation cathodique réactive pour produire avec des rendements industriels élevés, des vitrages plans ou bombés, revêtus d'une couche d'oxyde d'indium étain de résistivité minimum. La méthode retenue, qui consiste à déposer sur du verre à température ordinaire, par pulvérisation cathodique réactive à partir d'une cible d'indium étain une couche d'ITO sous oxydée qui possède un coefficient d'absorption supérieur à 7 500 cm$^{-1}$ avant de faire subir à l'ensemble verre + couche un traitement thermique dont au moins une phase est réductrice, présente l'avantage d'une méthode sûre et reproductible qui fournit finalement, quelle que soit l'épaisseur de la couche, la conductibilité - correspondant à cette épaisseur - qu'on souhaitait atteindre.

Les figures qui accompagnent la description de l'invention serviront à l'illustrer

- la figure 1 montre comment évolue la transmission lumineuse d'un verre à couche d'ITO au cours des phases de production,
- la figure 2 représente la relation expérimentale entre l'intensité lumineuse de la raie de l'indium dans le plasma pendant le dépôt et le taux d'oxygène dans l'atmosphère de l'enceinte,
- la figure 3 montre l'interdépendance du coefficient d'absorption et du taux d'oxygène dans l'atmosphère de l'enceinte,
- quant à la figure 4, elle permet de relier directement le coefficient d'absorption intrinsèque à l'intensité lumineuse de la raie de l'indium dans le plasma.

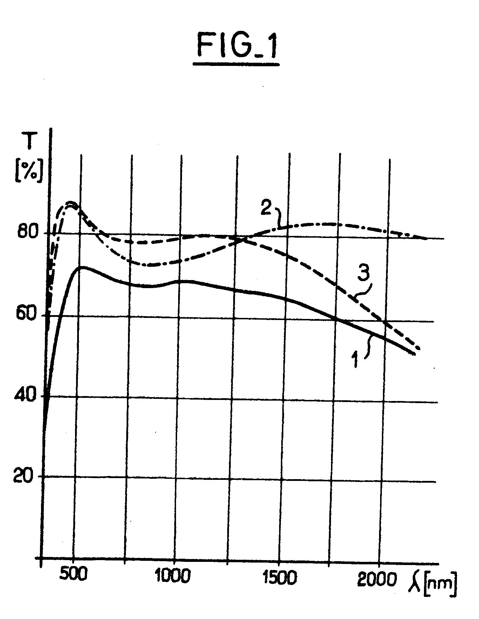

Au cours des phases successives de la production d'une couche d'ITO à forte conductibilité les caractéristiques optiques de la couche évoluent très sensiblement. On voit ainsi sur la figure 1 trois états successifs d'une couche d'une épaisseur de 90 nm sur du verre silico-sodo-calcique de 4 mm. La courbe 1 représente la transmission de l'échantillon avec la couche sous oxygénée à sa sortie de l'installation de pulvérisation cathodique, la courbe 2, le même échantillon après un traitement thermique à l'air à 550°C pendant 20 minutes. Quant à la courbe 3, elle montre la transmission de l'échantillon terminé, après son recuit à 500°C dans une atmosphère d'azote comportant 1 % d'hydrogène pendant 30 minutes.

Ce sont la transmission mesurée à 550 nm pour la courbe 1 et la réflexion correspondante qui, compte-tenu de l'épaisseur d (ici 90 nm), permettent de calculer le coefficient d'absorption intrisèque $\alpha$ 550 indépendant de l'épaisseur, selon la formule :

$$\alpha_{550} = \frac{-\operatorname{Ln}\dfrac{T}{1-R}}{d}$$

La réflexion étant ici de 0,15, il s'ensuit que $\alpha_{550}$ est ici égal à :

$$\alpha_{550} = \frac{-\operatorname{Ln}\dfrac{0,72}{1-0,15}}{90.10^{-7}} \text{ cm}^{-1}$$

$$= 18\ 000 \text{ cm}^{-1}$$

La formule $\dfrac{T}{1-R} = e^{-\alpha d}$ est une formule approchée.

Elle ne tient pas compte en particulier de l'aspect interférentiel de la couche. Il faudrait en toute rigueur utiliser les formules de l'optique des couches minces développées par Abeles (Advanced Optical Techniques, 1967, pp. 143-188, North Holland Publ. Co.). Il est à noter qu'avec la formule ci-dessus le coefficient d'absorption n'est pas tout à fait égal au coefficient d'absorption $\dfrac{4\pi k}{\lambda}$ où k est l'indice d'absorption de la couche pour la longueur d'onde $\lambda$.

Toutefois elle a l'avantage d'être simple (il suffit de mesurer R et T) et son domaine de validité est large :

$(2.10^3 \text{ cm}^{-1} \leqq \alpha \leqq 100.10^3 \text{cm}^{-1})$. A l'intérieur de ce domaine l'écart est inférieur à 15 %.

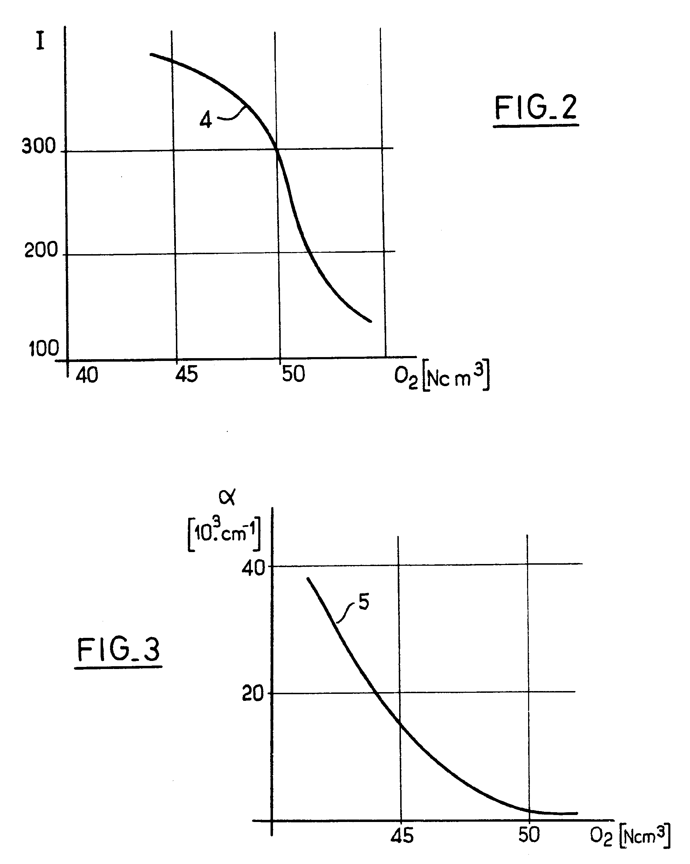

La figure 2 concerne des mesures optiques effectuées à l'aide d'un monochromateur réglé sur la longueur d'onde d'émission de l'indium (3256 Å) et équipé d'une optique qui vise le plasma autour de la cathode pendant la pulvérisation. On mesure le signal électrique à la sortie d'une cellule et on compare le signal pour des atmosphères composées d'argon et d'oxygène où la proportion de ce dernier gaz varie. La courbe 4 montre les variations de l'intensité de la raie de l'indium (unités relatives) en fonction du débit d'oxygène (centimètres cubes ramenés aux conditions normales de température et de pression pendant une minute).

Dans une installation industrielle de pulvérisation cathodique, la pression partielle des différents gaz est variable d'un endroit à l'autre en fonction par exemple des emplacements des entrées de gaz, de la présence ou non du substrat. De plus, dans le temps, cette pression partielle varie également selon la phase de production en cours. Dans le cas de la pulvérisation cathodique réactive, en particulier de l'oxydation de l'indium étain, la réaction chimique, se produit entre le moment où la particule de métal est arrachée de la cible et le moment où la couche déposée sur le substrat quitte la zone du plasma réactif. Pour maîtriser la réaction d'oxydation, il est connu de contrôler la luminescence du plasma, c'est ainsi que le brevet FR 2 503 190 propose de maintenir constante l'émission lumineuse de manière à stabiliser la réaction. La courbe 4 de la figure 2 permet, sur une installation donnée, de retrouver par une simple mesure spectrale, des conditions stoechiométriques souhaitées.

La figure 3 montre la relation qui existe entre les conditions oxydantes du dépôt d'ITO par pulvérisation cathodique réactive et le coefficient d'absorption intrinsèque, $\alpha_{550}$ de la couche obtenue en sortie de l'installation sous vide. En abscisse, on a fait figurer le débit d'oxygène (nombre de centimètres cubes, dans les conditions normales de température et de pression, qui sont introduits chaque minute dans l'installation). Le coefficient $\alpha_{550}$ qui figure en ordonnée s'exprime ici en milliers de cm$^{-1}$. La courbe 5 de la figure 3, comme la courbe 4 de la figure 2 sert à l'étalonnage de l'installation : quand on veut obtenir une couche dont le coefficient d'absorption intrinsèque soit supérieur à un certain seuil, la courbe 5 permet de déterminer quelles sont les taux d'oxygène dans l'atmosphère qui permettront de l'obtenir. De même, dans un deuxième temps, on peut déterminer grâce à la courbe 4 de la figure 2 quel est le domaine d'intensités lumineuses pour la raie de l'indium dans le plasma dans lequel il faut rester si l'on veut être sûr de garder le bon taux d'oxygène, donc les bonnes valeurs de $\alpha_{550}$.

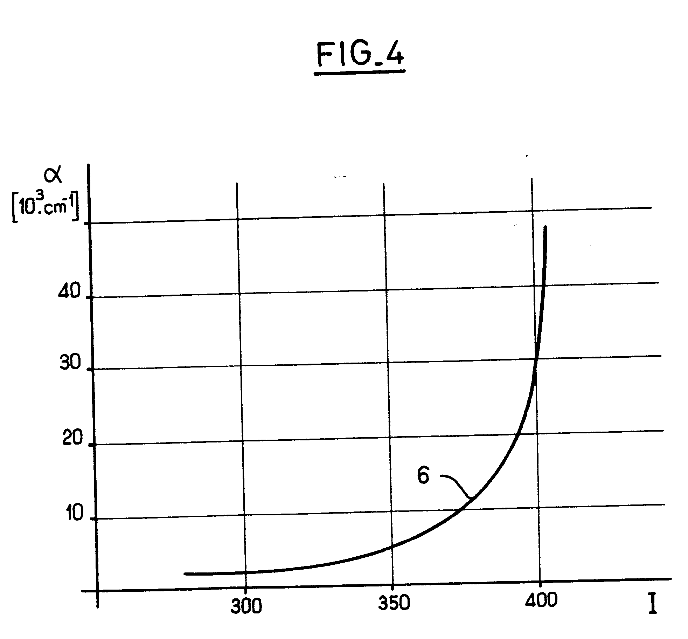

Pour simplifier la maîtrise de la réaction, on utilise de préférence une courbe du type de celle de la courbe 6 présentée figure 4, celle-ci permet de relier directement pour une installation donnée et pour des conditions de dépôt définies, le coefficient d'absorption de la couche à l'intensité lumineuse de la raie de l'indium. On peut ainsi, sur l'installation en question, retrouver facilement les conditions fournissant une couche ITO avec le coefficient d'absorption souhaité.

La manière de mettre en oeuvre l'invention apparaîtra claire ment au cours de la description qui va suivre qui sera éclairée par des exemples.

Chaque installation de pulvérisation cathodique a ses caractéristiques propres ce qui a pour conséquence qu'il est particulièrement difficile d'extrapoler les conditions d'une installation sur une autre dans le but d'obtenir les mêmes résultats. C'est un des avantages de la méthode proposée que de simplifier cette transposition dans le cas des couches d'ITO.

Pour produire sur une installation de pulvérisation cathodique, une couche d'ITO selon le procédé de l'invention on procède de la manière suivante : l'installation est équipée d'une cathode avec une cible constituée d'un alliage d'indium et d'étain comprenant au moins 2 % d'étain en poids et de préférence 10 %. L'installation comprend un système de visée optique permettant d'obtenir sur la fente d'entrée d'un monochromateur, l'image du plasma qui entoure la cible au moment de la pulvérisation. Le monochromateur est réglé de préférence sur une raie caractéristique, par exemple une raie de l'indium, on choisit avantageusement celle qui a une longueur d'onde voisine de 3256 angströms mais on pourrait également contrôler une raie de l'oxygène ou toute autre grandeur optique mesurée sur le plasma. A la sortie du monochromateur, un détecteur tel qu'une cellule photoélectrique permet de mesurer un signal électrique proportionnel à l'intensité de la raie en question. On peut par ailleurs introduire dans l'enceinte les gaz habituels - particulièrement l'argon - auxquels on peut mélanger dans des proportions variables, de l'oxygène.

La première phase consiste à étalonner l'installation c'est-à-dire, à relever des courbes anologues à celles de la figure 2, de la figure 3 et de la figure 4.

Après avoir placé l'installation dans les conditions habituelles en ce qui concerne le vide et les conditions électriques (tension, puissance) appliquées à la cathode, on fait donc varier les proportions d'oxygène introduit dans l'argon et l'on mesure après stabilisation, le signal donné par la cellule qui se trouve devant la fente de sortie du monochromateur.

On réalise ainsi un certain nombre d'échantillons de couches d'ITO sur des supports en verre introduits dans l'enceinte à température ordinaire. Chaque échantillon correspond à des conditions de dépôt définies particulièrement en ce qui concerne les paramètres tels que pression, débits des gaz, tension, puissance, vitesse de défilement.

Après leur sortie de l'installation, les échantillons sont mesurés. On détermine l'épaisseur de la couche, par exemple, avec un palpeur mécanique, puis à l'aide d'un spectrophotomètre, on mesure ses caractéristiques à la longueur d'onde de 550 nm : transmission et réflexion $T_{550}$ et $R_{550}$. On calcule alors à l'aide des formules habituelles, le coefficient d'absorption intrinsèque de la couche, $\alpha_{550}$. Ces différentes valeurs de $\alpha$, associées aux valeurs correspondantes du taux d'oxygène, elles-mêmes associées chacune à une intensité lumineuse de la raie de l'indium dans le plasma lors du dépôt permettent d'étalonner l'installation et en particulier de tracer une courbe du type de celle de la courbe 6 de la figure 4.

La mise en oeuvre de l'invention consiste alors à se placer dans les conditions qui fournissent une valeur de $\alpha_{550}$ supérieure à 7 500 cm$^{-1}$. On a en effet constaté que, d'une manière surprenante, si le coefficient d'absorption intrinsèque de la couche à sa sortie de l'installation de pulvérisation cathodique dépassait cette valeur, alors, la résistivité à l'issue des traitements thermiques habituels était optimale, c'est-à-dire, inférieure à 3,5 10$^{-4}$ et couramment de 2.10$^{-4}$ ohm.centimètre. L'évaluation de la résistivité $\rho$ ,se fait par les méthodes habituelles : après une mesure de la résistance de la couche par la méthode des quatre points, mesure qui fournit une valeur R carrée en ohms, on calcule $\rho$ par la formule :

$$\rho = R.e, \text{ où } e \text{ est l'épaisseur de la couche.}$$

Les traitements thermiques qui terminent le processus de fabrication du verre à couche d'ITO sont bien connus et divers, on préfère un premier traitement en atmosphère oxydante qui augmente la transparence de la couche. Il peut être d'autant plus court que la température est plus élevée et peut par conséquent être effectué pendant le bombage thermique du verre.Il est suffisant lorsque la transmission lumineuse de la couche est stabilisée mais il peut continuer pour d'autres raisons. Un deuxième traitement doit avoir un effet réducteur sur la couche, il est fait de préférence en atmosphère réductrice telle que constituée d'azote et d'hydrogène ou d'azote et de monoxyde de carbone, mais il pourrait également être effectué sous vide, ou par un autre moyen, il peut être réalisé immédiatement à la fin du traitement oxydant sans que l'échantillon ne refroidisse, par exemple à l'issue du bombage thermique.

Les trois exemples qui vont suivre montreront comment l'application de la méthode conduit au résultat recherché. Le quatrième exemple montrant, quant à lui, ce qui se produit lorsqu'on sort du domaine de l'invention.

Exemple 1 : l'installation de pulvérisation cathodique est de grand volume, la cathode verticale est du type décrit dans le brevet US 4 116 806, sa largeur est de 9 cm, la cible est en indium-étain 90-10, le verre-support a les dimensions 30 x 30 cm et son épaisseur est de 4 mm, il est vertical et mobile. Le verre se déplace devant la cathode à une vitesse de 10 cm/mn, la puissance appliquée est de 0,5 watt/cm². Le gaz vecteur est de l'argon, la pression de l'enceinte est de 400 Pa(3mTorr), le débit d'oxygène est de 170 cm³/mn (ramené aux conditions normales de température et de pression, CNTP), l'échantillon passe cinq fois devant la cathode.

A sa sortie de l'installation, l'échantillon est mesuré, l'épaisseur de la couche est de 330 nm, son absorption lumineuse à la longueur d'onde de 550 nm est de 0,28, ce qui correspond à un coefficient d'absorption intrinsèque de 10 000 cm$^{-1}$, la résistance électrique est de 160 ohms par carré ce qui correspond à une résistivité de 5,3.10$^{-3}$ ohms.cm. L'échantillon est alors porté à une température de 550°C à l'atmosphère ambiante pendant une demi-heure. A l'issue de ce premier recuit oxydant, on porte l'échantillon à 525°C pendant trente minutes dans une atmosphère composée de 99 % d'azote et de 1 % d'hydrogène. A la sortie de ce deuxième traitement thermique, après refroidissement, les caractéristiques optiques et électriques sont mesurées, à nouveau, l'absorption à 550 nm n'est plus que de 0,06 quant à la résistance surfacique, elle est de 8,8 ohms par carré. Après calcul, on trouve ainsi une résistivité de la couche.

$\rho$ = 2,9.10$^{-4}$ ohms.cm

Exemple 2 : l'installation est une unité de pulvérisation cathodique de laboratoire équipée de cathodes du type décrit dans le brevet US-A-4 166 018 de 12 cm de large. La cible est faite d'un alliage d'indium tain 90-10 (en poids) la cible est horizontale, au-dessus du substrat qui se déplace devant elle à 8 cm de distance.

La puissance électrique est de 1,2 W/cm². Le gaz produisant la pulvérisation est de l'argon, l'oxygène est introduit mélangé à l'argon ; la quantité d'oxygène introduite est de 13 cm³/mn CNTP ; la pression globale est de 1070 Pa(8mTorr). On effectue un seul passage devant la cible à une vitesse de 4 cm/min. On obtient ainsi une couche d'une épaisseur de 510 nm avec une absorption A = 62 % ce qui correspond à $\alpha_{550}$ = 23 000 cm$^{-1}$. La résistance carrée de la couche mesurée est de 18 ohms soit donc une résistivité = 10$^{-3}$ ohm.cm.

On effectue alors les deux traitements thermiques, le premier à l'air à 500°C pendant 30 minutes, le second également pendant 30 minutes à 500°C dans une atmosphère d'azote à 1 % d'hydrogène. Les mesures finales ont montré que la couche d'ITO avait une bonne transparence (A$_{550}$ = 10 %) et une bonne conductivité : $\rho$= 1,8 10$^{-4}$ ohm.cm.

Exemple 3 : l'installation et les conditions étaient celles de l'exemple 1 à l'exception de :
- débit d'oxygène : 100 cm³/mn (CNTP)
- puissance : 0,38 W/cm²
- vitesse 8,6 cm/mn
- nombre de passes : 6

Les traitements thermiques étaient également identiques à ceux de l'exemple 1.

Les résultats ont été :
- couche avant les recuits : épaisseur 400 nm
$\alpha_{550}$   = 12 000 cm$^{-1}$
$\rho$      = 8.10$^{-3}$ ohm.cm

Après traitement thermiques, l'absorption à 550 nm était de 5 % et la résistivité de 2,8.10$^{-4}$ ohm.cm.

Exemple 4 : ce quatrième exemple présente, à titre de comparaison, une couche dont les conditions de préparation ne correspondent pas au procédé selon l'invention. L'installation est la même que dans l'exemple 3, les conditions ne sont pas différentes à l'exception du nombre de passages de l'échantillon devant la cathode qui n'est ici que de quatre.

A sa sortie de l'installation de vide, on mesure les caractéristiques de la couche, son épaisseur est de 270 nm, sa résistance carrée est de 148 ohms et son absorption à 550 nm, de 0,12. Les calculs fournissent par conséquent $\alpha_{550}$ = 5.10$^3$ cm$^{-1}$ et $\rho$ = 4.10$^{-3}$ ohm.cm.

On fait subir à l'échantillon les traitements thermiques décrits dans l'exemple 1 et après refroidissement on mesure à nouveau les caractéristiques de la couche ITO, celles-ci sont, absorption à 550 nm = 0,04, résistivité = 4.7.10$^{-4}$ ohm.cm.

On voit ainsi, à la lumière des exemples précédents dont les trois premiers sont conformes à l'invention, que celle-ci permet, à la suite d'étalonnages simples de l'installation, d'obtenir des couches d'ITO transparentes et très conductrices sur des installations différentes et dans des conditions très diverses en contrôlant simplement les caractéristiques de l'émission lumineuse du plasma pendant le dépôt.

**Revendications**

1. Procédé de contrôle de la pulvérisation cathodique réactive pour l'obtention d'un verre revêtu d'une couche très conductrice à base d'oxyde d'indium-étain comprenant d'abord une première phase de dépôt réactif à partir d'une cible d'un alliage d'indium avec au moins 2 % d'étain et un mélange d'argon et d'oxygène dans le plasma et un traitement thermique ultérieur comprenant une phase réductrice, **caractérisé en ce qu'**à l'issue de la première phase, on vérifie que le coefficient d'absorption intrinsèque α de la couche est supérieur à un seuil donné, fonction de la résistivité ρ recherchée.

2. Procédé de contrôle selon la revendication 1, **caractérisé en ce que**, pour obtenir une résistivité ρ inférieure ρ 3,5.10$^{-4}$ ohms.cm avec un alliage sensiblement à 10 % d'étain, on vérifie que le coefficient d'absorption intrinsèque α de la couche est supérieur à 7500 cm$^{-1}$ pour une longueur d'onde de sensiblement 550 nm.

3. Procédé de contrôle selon la revendication 1 ou 2, **caractérisé en ce que** pour obtenir une résistivité ρ inférieure à 2,5.10$^{-10}$ ohms.cm avec un alliage sensiblement à 10 % d'étain, on vérifie que le coefficient intrinsèque α de la couche est supérieur à 23 000 cm$^{-1}$ pour une longueur d'onde de sensiblement 550 nm.

4. Procédé selon l'une des revendications précédentes, **caractérisé en ce que** le coefficient d'absorption intrinsèque α est déterminé à partir des mesures de l'épaisseur de la couche d et des transmission T et réflexion R de la couche à une longueur d'onde de sensiblement 550 nm, le calcul se faisant selon la formule:

$$\alpha = \frac{-\,Ln\,\dfrac{T}{1-R}}{d}$$

5. Procédé de contrôle selon l'une des revendications précédentes, **caractérisé en ce qu'**un dispositif de mesure de l'intensité lumineuse des raies émises par le plasma est installé **et en ce que** un étalonnage associant l'intensité d'une raie du plasma et le taux d'oxygène dans le plasma a été effectué **et en ce que** le coefficient d'absorption intrinsèque α prévu est déduit de la mesure de l'intensité lumineuse d'une raie du plasma.

6. Procédé selon la revendication 6, **caractérisé en ce que** c'est une raie de l'indium qui est mesurée.

## Patentansprüche

1. Verfahren zur Steuerung des reaktiven Kathodenzerstäubung zur Erzielung eines Glases, das mit einer noch leitfähigen Schicht auf der Basis von Indium-Zinnoxid beschichtet ist, die zunächst eine erste Phase eines reaktiven Niederschlags aus einem Indiumlegierungtarget mit zumindest 2% Zinn und einer Mischung von Argon und Sauerstoff im Plasma und eine nachträgliche thermische Behandlung umfaßt, die eine reduktive Phase beinhaltet, **dadurch gekennzeichnet, daß** bei Ablauf der ersten Phase kontrolliert wird, daß der intrinsische Absorptionskoeffizient α der Schicht größer als eine gegebene Schwelle abhängig vom gesuchten Widerstand ρ ist.

2. Steuerungsverfahren gemäß Anspruch 1, **dadurch gekennzeichnet, daß** man, um einen Widerstand ρ < 3,5 x 10$^{-4}$ Ohm x cm mit einer Legierung von 10 % Zinn zu erhalten, kontolliert, daß der intrinsische Absorptionskoeffizient α der Schicht über 7500 cm$^{-1}$ für eine Wellenlänge von 550 nm liegt.

3. Steuerverfahren gemäß Anspruch 1 oder 2, **dadurch gekennzeichnet, daß** man, um einen Widerstand ρ < 2,5 x 10$^{-10}$ Ohm x cm mit einer Legierung von 10 % Zin zu erhalten, kontrolliert, daß der intrinsische Koeffizient α der Schicht größer als 23000 cm$^{-1}$ für eine Wellenlänge von 550 nm ist.

4. Verfahren gemäß einem der obigen Ansprüche, **dadurch gekennzeichnet, daß** der intrinsische Absorptionskoeffizient α durch Messung der Schichtdicke d sowie der Transmission T und der Reflexion R der Schicht bei einer Wellenlänge von 550 nm bestimmt wird, wobei die Rechnung sich gemäß der Formel vollzieht:

$$\alpha = \frac{-\,Ln\,\dfrac{T}{1-R}}{d}$$

5. Steuerungsverfahren gemäß einem der obigen Ansprüche, **dadurch gekennzeichnet, daß** eine Vorrichtung zur Messung der Lichtintensität der vom Plasma emittierten Strahlen, vorgesehen ist, und daß eine Eichung, die die Intensität der Strahlung vom Plasma und die Sauerstoffrate in dem Plasma assoziiert, ausgeführt wird, und daß der vorgesehene intrinsische Absorptionskoeffizient α aus der Messung der Licht intensität der Strahlen des Plasmas erhalten wird.

6. Verfahren gemäß Anspruch 6, **gekennzeichnet dadurch, daß** der Strahl von Indium gemessen wird.

## Claims

1. Process for controlling the reactive cathodic sputtering for the production of a glass coated with a highly conducting film based upon indium-tin oxide, the process comprising, firstly, a first phase of reactive deposition from a target of an indium alloy comprising at least 2 % tin and a mixture of argon and oxygen in the plasma, and a subsequent thermal treatment comprising a reducing phase, characterized in that, at the end of the first phase, a check is made that the intrinsic absorption coefficient $\alpha$ of the film is above a given threshold, which is a function of the desired resistivity $\rho$.

2. Control process according to Claim 1, characterized in that, for obtaining a resistivity $\rho$ less than $3.5 \times 10^{-4}$ ohms.cm with an alloy having substantially 10 % tin, it is checked that the intrinsic absorption coefficient $\alpha$ of the film is higher than 7500 cm$^{-1}$ for a wavelength of substantially 550 nm.

3. Control process according to Claim 1 or 2, characterized in that, for obtaining a resistivity $\rho$ less than $2.5 \times 10^{-10}$ ohms.cm with an alloy comprising substantially 10 % tin, it is checked that the intrinsic coefficient $\alpha$ of the film is higher than 23000 cm$^{-1}$ for a wavelength of substantially 550 nm.

4. Process according to one of the preceding Claims, characterized in that the intrinsic absorption coefficient $\alpha$ is determined from measurements of the thickness of the film d and of the transmission T and reflection R of the film at a wavelength of substantially 550 nm, the calculation being performed according to the formula:

$$\alpha = \frac{-\operatorname{Ln}\dfrac{T}{1-R}}{d}$$

5. Control process according to one of the preceding Claims, characterized in that a device for measuring the luminous intensity of the spectral lines emitted by the plasma is installed and in that a calibration associating the intensity of a spectral line of the plasma with the oxygen content of the plasma has been carried out and in that the intrinsic absorption coefficient $\alpha$ envisaged is deduced from the measurement of the luminous intensity of a spectral line of the plasma.

6. Process according to Claim 5, characterized in that it is a spectral line of indium which is measured.

# FIG_1

FIG. 2

FIG. 3

# FIG.4